**Europäisches Patentamt**

**European Patent Office**

**Office européen des brevets**

(19)

(11) Publication number : **0 469 614 B1**

# (12) EUROPEAN PATENT SPECIFICATION

(45) Date of publication of patent specification :
**19.04.95 Bulletin 95/16**

(51) Int. Cl.$^6$ : **H01L 21/60, H01L 23/485**

(21) Application number : **91112967.4**

(22) Date of filing : **01.08.91**

(54) **Flip-chip semiconductor device.**

(30) Priority : **02.08.90 JP 205606/90**

(43) Date of publication of application :
**05.02.92 Bulletin 92/06**

(45) Publication of the grant of the patent :
**19.04.95 Bulletin 95/16**

(84) Designated Contracting States :
**DE FR GB**

(56) References cited :
**EP-A- 0 299 894**
**EP-A- 0 303 256**
**DE-A- 3 938 152**
**PATENT ABSTRACTS OF JAPAN vol. 14, no. 268 (E-939), 11 June 1990 ; & JP-A-2084747**

(73) Proprietor : **Dow Corning Toray Silicone Company, Limited**
**Mitsui Bldg. No. 6,**
**2-3-16, Nihonbashi-Muromachi,**
**Chuo-Ku**
**Tokyo 103 (JP)**

(72) Inventor : **Nakayoshi, Kazumi**
**6, 1-chome, Yushudai Nishi**
**Ichihara-shi, Chiba (JP)**
Inventor : **Mine, Katsutoshi**
**20-2, 7-chome, Aobadai**
**Ichihara-shi, Chiba Prefecture (JP)**

(74) Representative : **Spott, Gottfried, Dr.**
**Spott, Weinmiller & Partner**
**Sendlinger-Tor-Platz 11**
**D-80336 München (DE)**

EP 0 469 614 B1

Note : Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).

## Description

The present invention relates to a semiconductor device consisting essentially of a flip chip-type semiconductor element mounted on a base plate or substrate. More particularly, the present invention relates to a highly reliable flip chip-type semiconductor device.

Semiconductor elements are currently mounted on a substrate or base plate by such methods as wire bonding, referred to as a "face-up method" based on the orientation of the element, and by method employing solder bumps on the element, conductive epoxy resin adhesive, or conductive polyimide resin adhesive, referred to as "face-down" methods; and by the use of tape automated bonding (TAB).

In association with the recent trends in flip chip (LSI) technology of increasing integration and increasing functionality, the terminal or I/O pads on semiconductor elements are currently 100 micrometers square. However, in the future these dimensions will be only several tens of micrometers square, while the number of terminals will increase and the pad pitch will also become finer.

Packaging technologies which can accommodate high density mounting and higher pin counts include TAB, pin grid array (PGA) packages, and quad flat pack (QFP) packages. However, not only is TAB costly, but it requires a large bonding surface in order to ensure a low connection resistance. Also, IC packaging techniques such as PGA and QFP face limitations with regard to cost and high density mounting. These factors have resulted in a substantial increase in flip chip mounting as an alternative to these methods.

Flip chip mounting places a number of constraints on terminal miniaturization using solder bump methodology for attaching the semiconductor element to the base plate. As the size of the semiconductor element increases, bump cracking, poor contact at the bump surface, and ultimately an increase in the resistance at the contact point between the flip chip element and the substrate (faulty conduction) occur during reliability testing using techniques such as heat-cycle testing and heat-shock testing . These deficiencies are brought on by the thermal stresses generated by the mismatch in thermal coefficients of expansion (TCE) between the mounting substrate and the semiconductor element.

With regard to the use of a conductive epoxy resin adhesive or conductive polyimide resin adhesive in the solder bump method for connecting the terminals on the surface of the semiconductor element with corresponding terminals on the substrate, cracking in the glass, for example, when the mounting base plate is glass, or cracking in the conductive epoxy resin adhesive, is again produced by the mismatch in thermal coefficients of expansion between the semiconductor element and base plate.

Finally, the solder bump method is afflicted not only with solder cracking, but defective semiconductor elements cannot be repaired in this case.

In order to improve the semiconductor element's reliability in areas such as moisture resistance, the surface of the semiconductor element is typically protected with a resin sealant. However, when the surface of a semiconductor element that is bonded to a substrate by means of solder bumps is protected using a hard resin such as an epoxy resin, acrylic resin or polyimide resin, the aforementioned problems of bump cracking and loose contact at the bump occur to an even greater extent. Other semiconductor mounting means are disclosed in EP 30 3256.

An objective of the present invention is to eliminate the problems associated with prior art methods and materials for mounting flip-chip type semiconductor devices on substrates using the solder bump method.

The present inventors carried out extensive research directed at finding new materials for bonding flip-chip type semiconductor elements to a base plate or other substrate where these materials prolong the useful life of the resultant device. Their invention is based on the use of a conductive silicone elastomer to bond the terminals of the semiconductor element and the use of an electrically insulating elastomeric sealant on the active surfaces of the semiconductor element.

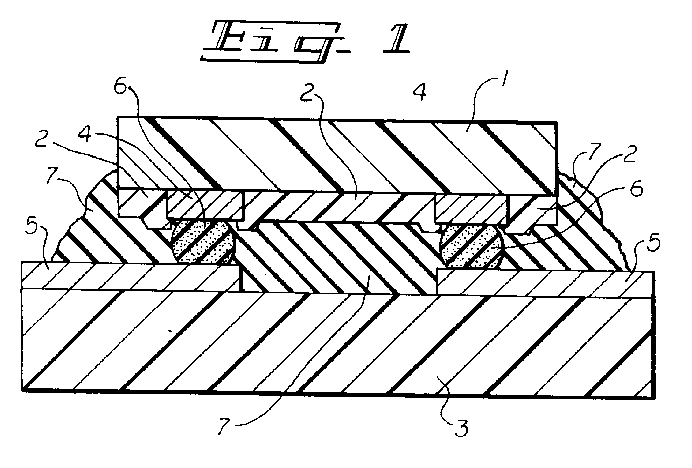

In the drawing, figure 1 is a schematic diagram taken along a vertical section of one embodiment of a flip chip (LSI chip) semiconductor device according to the present invention.

An LSI chip 1 is mounted on a glass plate 3. The active surface of the chip is coated with a passivation film 2 having an outer surface facing the glass plate 3.

A plurality of electrical terminal pads 4 are present on the active surface of LSI chip 1 . This surface faces the glass base plate 3. The electrical terminal pads 4 are contiguous with the passivation film 2. A plurality of substrate terminals 5 corresponding in position to the terminal pads 4 are present on the surface of glass base plate 3. Each terminal pad 4 is connected to its opposing base plate terminal 5 by a layer of conductive silicone rubber 6. The conductive silicone rubber 6 both bonds and electrically connects each electrical terminal pad 4 to the corresponding base plate terminal 5.

A cold-resistant insulating silicone rubber 7 fills all of the space between the passivation film 2 on LSI chip 1 and glass base plate 3.

This invention provides a semiconductor device comprising 1) a flip chip-type semiconductor element comprising an active surface and a plurality of electrical terminal pads located on said active surface, and 2) a base plate containing a plurality of electrical terminal pads corresponding to the terminal pads of said semiconductor element, where the electrical terminal pads of said semiconductor element are connected to the corresponding terminal pads on said base plate by means of a conductive silicone elastomer exhibiting a tensile Young's modulus value no larger than 100 kgf/cm$^2$ (981 N/cm$^2$) at 25 degrees Centigrade and where said active surface is coated with an electrically insulating elastomeric sealant that occupies the space between said active surface and said base plate.

The semiconductor device of the present invention will now be explained in detail.

The semiconductor device according to the present invention encompasses all of the following types: bipolar, MOS, and HEMT devices from the standpoint of operating principle; logic IC devices and memory IC devices from the standpoint of function; and integrated circuits (IC), hybrid IC devices, and discrete semiconductors (for example, transistors, thyristors) from the standpoint of degree of integration.

The material of the semiconductor element portion of the present device is selected from a group that includes but is not limited to silicon, gallium arsenide and cadmium sulfide.

The material from which the mounting plate or substrate portion of the present device is fabricated is selected from a group that includes but is not limited to glass base plates, ceramic base plates, composite metal base plates and plastic base plates.

The electrical terminal regions on the surface of the semiconductor element may be previously affixed aluminum bonding pads or gold bumps. The active surface of the semiconductor element are typically coated with a layer of material referred to as a passivation coating.

The terminal pads on the surface of the semiconductor element and the corresponding terminals on the base plate are connected by a layer of conductive silicone elastomer. One of the key features considered responsible for the reliable performance of the present semiconductor devices is the tensile Young's modulus of the conductive silicone elastomer, which at 25 degrees Centigrade should not exceed 100 kgf/cm$^2$. This Young's modulus is lower than for conductive epoxy resin adhesives, which leads to a relaxation of the stress concentrations occurring at the bonding pads on the semiconductor element, in the connection region of the circuit board, and in the bump, and results in the maintenance of low connection resistance values.

The conductive silicone elastomer preferably contains a conductive filler such as silver particles and cures by a hydrosilylation reaction. This type of silicone composition offers the advantages of excellent processability and high purity. As used in this specification the term "silicone elastomer" encompasses both silicone rubbers and silicone gels. The electrically conductive elastomer is cured while in contact with the terminal pads on the surface of the semiconductor element and the corresponding terminals on the base plate or substrate.

A second characterizing feature of the present invention is the electrically insulating elastomeric sealant used to coat at least the active surface of the semiconductor element and fill the space between this active surface and the base plate on which the semiconductor element is mounted. This sealant protects the semiconductor element from external influences and achieves long-term maintenance of a low connection resistance even during reliability testing.

The insulating elastomeric sealant is most preferably a silicone elastomer sealant followed in order of preference by low-stress epoxy resin sealants. Preferred self-bonding silicone elastomer compositions are cured by a hydrosilylation reaction while in contact with at least the active surface of the semiconductor element. This type of silicone elastomer composition offers the advantage of high purity. As in the case of the electrically conductive elastomer, both silicone rubbers and silicone gels may be employed as the electrically insulating sealant.

As a result of using a conductive silicone elastomer in combination with an electrically insulating elastomer to fill all of the space between the active surface of the semiconductor element and the base plate, the resultant semiconductor device according to the present invention is characterized by an excellent heat-cycle resistance and heat-shock resistance and by an excellent moisture resistance and resistance to standing at low temperatures. Furthermore, it avoids bump cracking, loose contact, and an increase in the connection resistance (faulty conduction) even in the face of the thermal stresses generated by the TCE mismatch between semiconductor element and mounting substrate as the size of the semiconductor element increases.

The following example describes a preferred embodiment of the present flip-chip semiconductor devices, and should not be interpreted as limited the present invention as defined in the accompanying claims. Unless otherwise indicated, all of the properties reported in the examples were measured at 25° C.

## Example 1

Referring to the accompanying drawing identified as Figure 1, an LSI chip $\underline{1}$ (4 mm x 7 mm) is mounted on glass plate $\underline{3}$. The active surface of the chip is coated with a passivation layer $\underline{2}$ surface facing the glass plate 3.

A total of 120 terminal pads 4 are present on the surface of LSI chip 1 which faces the glass base plate 3, and these terminal pads 4 are contiguous with the passivation layer 2. Each of the 120 terminals 5 located on the base plate faces the corresponding terminal pad on the LSI chip. Each pair of terminal pads is connected together by a layer of conductive silicone rubber 6. The conductive silicone rubber 6 both bonds and electrically connects each terminal pad 4 to the corresponding base plate terminal 5.

This conductive silicone rubber 6 comprises a silver powder-filled self-bonding silicone rubber composition which has been thermally cured by a platinum-catalyzed hydrosilylation reaction while in contact with terminal pad 4 and base plate terminal 5. This conductive silicone rubber 6 has a volume resistivity of 4 x $10^{-4}$ ohm-cm and a tensile Young's modulus of 50 kgf/cm$^2$.

A cold-resistant insulating silicone rubber 7 is fills the all of the space between the coated active surface of the LSI chip 1 and glass base plate 3. This insulating silicone rubber 7 bonds to the sides of the LSI chip 1 itself, to the passivation coating 2 on the active surface LSI chip 1, and to the terminal pads 4, and also bonds to the glass base plate 3 and to the base plate terminals 5 on the surface of the base plate.

This insulating silicone rubber 7 comprises a self-bonding silicone rubber and is obtained by curing a curable organosiloxane composition exhibiting a viscosity of 3,000 cp prior to curing. The composition forming the insulating silicone rubber is formed by a thermally initiated hydrosilylation reaction while the composition is in contact with the passivation film 2 of LSI chip 1, the terminal pads 4, the sides of LSI chip 1 itself, the glass base plate 3, and the base plate terminals 5 on the surface thereof.

The hardness of the cured elastomer was 15 when measured by a type A hardness meter described in Japanese Industrial Standards (JIS) K 6301 and a volume resistivity of 1.5 x $10^{15}$ ohm-cm; it does not have a crystallization temperature; and it has a glass-transition temperature of -120 degrees Centigrade.

Reliability testing was conducted using 30 of the semiconductor devices depicted in Figure 1 and the following tests. The results of the testing are reported in Table 1.

Heat-Cycle Resistance:

1 cycle = the semiconductor device is held for 30 minutes in air at -40 degrees Centigrade, for 5 minutes in air at +25 degrees Centigrade, for 30 minutes in air at +85 degrees Centigrade, for 5 minutes in air at +25 degrees Centigrade, then for 30 minutes in air at -40 degrees Centigrade.

The cycle is repeated until bump cracking is produced in 50% of the semiconductor devices or until connection resistance value reaches twice the initial value. The smaller number of cycles is the one reported.

Heat-Shock Resistance:

1 cycle = the semiconductor device is exposed for 30 minutes in air at -40 degrees Centigrade, then immediately exposed for 30 minutes to air maintained at a temperature of +85 degrees Centigrade. The results are reported as smaller of the number of cycles required until either bump cracking is produced in 50% of the semiconductor devices or until the connection resistance value increases to twice the initial value.

Low Temperature Resistance

The semiconductor device is exposed in air at -40° , and the result is reported as the time required for the connection resistance to double.

Moisture Resistance

The semiconductor device is exposed to air at 85° C and 85% relative humidity and the life is designated as the time required for the connection resistance to reach a value twice that of the initial value.

Comparison Example 1

Thirty semiconductor devices were prepared exactly as in Example 1, with the exception that a conductive epoxy resin adhesive was used in place of the conductive silicone rubber identified as 6 in figure 1, and an insulating epoxy resin was used in place of silicone rubber identified as 7 in figure 1. Reliability testing was conducted on these comparative devices as described in Example 1, and these results are reported in Table 1.

The conductive epoxy resin adhesive had the following characteristics: filler = silver powder, curing agent = amine, post-cure volume resistivity = 1 x 10$^{-4}$ ohm-cm, tensile Young's modulus = 650 kg/cm$^2$.

The insulating epoxy resin had the following characteristics: pre-cure viscosity = 3,000 cp, curing agent = amine, post-cure volume resistivity = 3.0 x 10$^{15}$ ohm-cm, tensile Young's modulus = 850 kg/cm$^2$.

<u>Comparison Example 2</u>

Thirty semiconductor devices were prepared exactly as described in Comparison Example 1, with the exception that solder was used in place of the conductive epoxy resin adhesive. These were subjected to reliability testing as in Comparison Example 1, and these results are reported in Table 1.

<u>Table 1</u>

| Property | Example 1 | Comparison Example 1 | Comparison Example 2 |
|---|---|---|---|
| heat-cycle resistance (number of cycles) | $\geq$ 1000 | $\leq$ 200 | $\leq$ 100 |
| heat-shock resistance (number of cycles) | $\geq$ 1000 | $\leq$ 200 | $<$ 100 |
| resistance to holding at low temperature (hours) | $\geq$ 1000 | $\leq$ 200 | $<$ 200 |
| moisture resistance (hours) | $\geq$ 1000 | $\leq$ 350 | $\leq$ 300 |

## Claims

1. A semiconductor device comprising 1) a flip chip-type semiconductor element (1) comprising an active surface and a plurality of electrical terminal pads (4) located on said active surface, and 2) a base plate (3) containing a plurality of electrical terminal pads (5) corresponding to the terminal pads of said semiconductor element, where the electrical terminal pads of said semiconductor element are connected to the corresponding terminal pads on said base plate by means of a conductive silicone elastomer (6) exhibiting a tensile Young's modulus value no larger than 100 kgf/cm$^2$ (981 N/cm$^2$) at 25 degrees Centigrade and where said active surface is coated with an electrically insulating elastomeric sealant (7) that occupies the space between said active surface and said base plate.

2. A semiconductor device according to claim 1 where said electrically insulating elastomeric sealant is a silicone sealant.

3. A semiconductor device according to claim 2 where the conductive silicone elastomer and the electrically insulating elastomeric sealant cure by means of a hydrosilylation reaction.

4. A semiconductor device according to claim 3 where said electrically conductive silicone elastomer contains finely divided silver as a conductive filler.

**Patentansprüche**

1. Halbleitervorrichtung umfassend
   1) ein Flip-Chip-Halbleiterelement (1), das eine aktive Oberfläche und eine Vielzahl von elektrischen Anschlußaugen (4), die auf der aktiven Oberfläche angeordnet sind, umfaßt und
   2) eine Basisplatte (3), die eine Vielzahl von elektrischen Anschlußaugen (5) aufweist, die den Anschlußaugen auf dem Halbleiterelement entsprechen, wobei die elektrischen Anschlußaugen des Halbleiterelementes mit den entsprechenden Anschlußaugen auf der Basisplatte durch ein leitendes Siliconelastomer (8) verbunden sind, das einen Wert für das Young'sche Modul von nicht mehr als 100 kgf/cm$^2$ (981 N/cm$^2$) bei 25°C aufweist und wobei die aktive Oberfläche mit einem elektrisch isolierenden Elastomerdichtungsmittel (7) beschichtet ist, das den Raum zwischen der aktiven Oberfläche und der Basisplatte einnimmt.

2. Halbleitervorrichtung nach Anspruch 1, wobei das elektrisch isolierende Elastomerdichtungsmittel ein Silicondichtungsmittel ist.

3. Halbleitervorrichtung nach Anspruch 2, wobei das leitende Siliconelastomer und das elektrisch isolierende Elastomerdichtungsmittel durch eine Hydrosilylierungsreaktion härten.

4. Halbleitervorrichtung nach Anspruch 3, wobei das elektrisch leitende Siliconelastomer fein verteiltes Silber als leitenden Füllstoff enthält.

**Revendications**

1. Dispositif à semiconducteur, comprenant 1°) un élément à semiconducteur du type "puce à bosses" comprenant une surface active et une pluralité de plages formant des bornes électriques (3) situées sur ladite surface active, et 2°) une embase comportant une pluralité de plages formant des bornes électriques (5) dudit élément à semiconducteur, les plages formant des bornes électriques dudit élément à semiconducteur étant connectées aux plages formant des bornes correspondantes sur ladite embase au moyen d'un élastomère conducteur à base de silicones (6) présentant un module de Young en traction non supérieur à 100 kgf/cm$^2$ (981 N/cm$^2$) à 25 degrés Celsius, et ladite surface active étant recouverte d'un agent d'étanchéité électriquement isolant à base d'élastomère (7) qui occupe l'espace compris entre ladite surface active et ladite embase.

2. Dispositif à semiconducteur selon la revendication 1, dans lequel ledit agent d'étanchéité électriquement isolant à base d'élastomère est un agent isolant à base de silicones.

3. Dispositif à semiconducteur selon la revendication 2, dans lequel l'élastomère conducteur à base de silicones et l'agent d'étanchéité électriquement isolant à base d'élastomère durcissent au moyen d'une réaction d'hydrosilylation.

4. Dispositif à semiconducteur selon la revendication 3, dans lequel ledit élastomère électriquement conducteur à base de silicones contient de l'argent finement divisé comme charge conductrice.

Fig. 1